# FASCICULE DE BREVET EUROPEEN

(11) **EP 2 364 075 B1**
(45) Date de publication et mention de la délivrance du brevet: **10.04.2019**
(21) Numéro de dépôt: 11155751.8
(22) Date de dépôt: 24.02.2011
(51) Int. Cl.: H05K 7/20

(54) **Module informatique pour centre d'hébergement informatique transportable**
Informatikmodul für transportables Informatik-Hostcenter
Computer module for transportable IT hosting centre

(30) Priorité: 03.03.2010 FR 1051546
(43) Date de publication de la demande: 07.09.2011
(73) Titulaire: BULL SAS, 78340 Les Clayes sous Bois (FR)
(72) Inventeur: Demange, Fabien, 78300, POISSY (FR); Depret, Nicolas, 78000, Versailles (FR)
(74) Mandataire: Santarelli

(56) Documents cités:
- WO-A1-2007/139559
- US-A1- 2006 082 263
- US-A1- 2008 123 288
- US-A1- 2009 251 860
- US-A1- 2010 114 356
- US-B1- 6 394 398
- US-B1- 7 278 273

## Description

La présente invention porte sur un module informatique pour centre d'hébergement informatique transportable de type à installation et désinstallation simplifiées, configuré dans au moins un container.

Les centres d'hébergement informatique ou centres de traitement de données, connus sous les terminologies anglophones « *data center* » ou « *server cluster* » sont des ensembles regroupant notamment des serveurs, des unités de stockage de données ou des équipements de télématique prenant la forme de rangées d'armoires informatiques (« *racks* ») dans lesquelles sont installées les dispositifs électroniques.

De tels centres incorporent typiquement des éléments de contrôle et de sécurité, un système de climatisation, des dispositifs anti-incendie ou des éléments de maintenance et de surveillance. Leur accès est préférentiellement limité à des personnes dûment autorisées. Ils nécessitent une alimentation électrique et des connexions aux réseaux de type Internet ou Ethernet ainsi que, généralement, une alimentation en eau pour la réfrigération.

De tels centres d'hébergement sont utilisés par de grandes et petites entreprises, des centres de recherche et des administrations. Ils peuvent aussi être loués en tout ou partie pour des périodes de temps variables.

Les besoins en capacité de stockage et de calculs augmentent rapidement, et il est aussi constaté que les besoins des utilisateurs peuvent être variables dans le temps.

Certains centres d'hébergement pouvant être installés et désinstallés sur demande se présentent sous forme d'éléments préfabriqués de type containers de transport de marchandises, répondant éventuellement à des normes de transport par camions ou navires, et embarquant les différents éléments matériels mentionnés précédemment sous une forme plus ou moins intégrée et prête à l'emploi.

On connaît de tels systèmes avec des armoires disposées le long d'une unique paroi latérale intérieure du container ou disposées le long des deux parois latérales intérieures du container. Cette disposition implique souvent que l'accès à une partie des armoires se fait par l'extérieur du container via des ouvertures dans la paroi latérale, ou par un déplacement de l'armoire dans l'allée, qui doit alors être suffisamment large.

Le document US 7278273, par exemple, divulgue un container qui comprend une allée centrale longitudinale.

L'utilisation d'un espace restreint a amené certains constructeurs à développer des armoires informatiques spécifiquement dédiées aux centres d'hébergement en containers.

Certains containers doivent être installés dans des espaces à accès sécurisé comme des hangars ou des parcs fermés, ce qui nécessite une infrastructure préalable ou un espace au sol important.

La consommation des containers en électricité et eau constitue également une préoccupation et il est souhaité d'une part de pouvoir implanter les centres dans des zones géographiques où l'électricité est à bas coût et d'autre part de diminuer l'empreinte carbone de l'installation. Des besoins en centres de calcul apparaissent également dans des espaces fortement contraints, comme des espaces off-shore.

Le document US 2009/0251860 décrit des containers pourvus chacun de deux modules informatiques comportant des équipements informatiques, lesquels containers et modules s'étendent suivant une même direction longitudinale.

Dans ce contexte, le déploiement rapide de grandes puissances de calcul à des coûts maîtrisés et ne nécessitant pas une infrastructure préalable reste un problème, que la présente invention a pour objet de résoudre.

Un objet de l'invention est, dans ce contexte, un module informatique pour centre d'hébergement informatique transportable configuré dans au moins un container, ledit au moins un container s'étendant horizontalement suivant une direction principale longitudinale, ledit module informatique comprenant un ensemble d'équipements informatiques formé par au moins deux armoires informatiques dressées les unes à côté des autres s'étendant horizontalement suivant une direction principale de développement, ainsi que des espaces d'accès aux deux faces latérales opposées dudit ensemble d'équipements informatiques, la direction principale de développement et la direction principale longitudinale étant sensiblement orthogonales.

Une telle configuration permet une gestion de l'espace dédié aux équipements informatiques compatible avec un accès facilité aux équipements et une circulation devant ceux-ci dans une direction perpendiculaire à la direction principale longitudinale.

En fonction de son implantation ou de sa destination, le container comprenant ledit module informatique comporte avantageusement au moins une porte sur une paroi latérale débouchant sur une allée de circulation transversale, ladite allée de circulation transversale comprenant l'un desdits espaces d'accès, la porte et l'allée pouvant être empruntées par un opérateur humain. Les allées de circulation transversales sont, de préférence, notamment constituées par des espaces d'accès de plusieurs modules informatiques voisins.

Selon une caractéristique avantageuse, le module informatique comporte de plus une allée de circulation longitudinale pouvant être empruntée par un opérateur humain. L'allée de circulation longitudinale relie les espaces d'accès d'un module informatique et permet à un opérateur d'accéder aux faces latérales opposées d'un module informatique. L'allée longitudinale longe, de préférence, une paroi du container.

Selon une caractéristique avantageuse, l'ensemble d'équipements informatiques d'un module informatique comprend au moins une rangée d'au moins deux armoires informatiques de forme parallélépipédique rectangle. Les armoires informatiques sont, de préférence, de type standard.

L'invention a aussi pour objet un container comprenant au moins un module informatique tel que celui décrit précédemment. Un tel container, facilement transportable, permet de répondre rapidement à des besoins informatiques de calcul et/ou de stockage.

Selon un mode de réalisation particulier, le container comprend au moins deux modules informatiques tels que décrits précédemment, les directions principales de développement des équipements informatiques des aux moins deux modules informatiques étant parallèles entre elles.

Selon une caractéristique avantageuse, les ensembles d'équipements informatiques respectifs desdits au moins deux modules présentent chacun une façade latérale portant une sortie d'air chaud d'un système de réfrigération, ces façades se faisant face. Cela permet notamment d'éviter que lorsqu'une armoire est ouverte pour des opérations de maintenance du côté du système de réfrigération, un souffle d'air chaud soit projeté sur l'admission d'air de l'armoire lui faisant face.

Selon une caractéristique avantageuse, chaque ensemble d'équipements informatiques desdits au moins deux modules comprend au moins un système de réfrigération, ledit système de réfrigération comprenant une alimentation hydraulique, ladite alimentation hydraulique étant issue d'une canalisation commune disposée par exemple sous un plancher entre les deux ensembles d'équipements informatiques desdits au moins deux modules informatiques.

Un autre objet de l'invention est un centre d'hébergement informatique comprenant au moins deux containers tels que présentés précédemment, les containers étant disposés parallèlement les uns aux autres et alignés dans une direction transversale à leur direction longitudinale.

Un tel centre d'hébergement informatique offre une puissance de calcul importante pouvant être déployée sur une surface dont la forme est contrainte ou les dimensions sont limitées. En outre, la combinaison de containers permet d'ajuster la capacité informatique mise à disposition.

Selon une caractéristique de mise en oeuvre, au moins deux containers alignés dans une direction transversale à la direction longitudinale des containers sont reliés par un couloir, par exemple un couloir réalisé en éléments préfabriqués, permettant notamment à un opérateur de passer d'un container à un autre sans sortir de l'enceinte formée par les parois des containers et du couloir.

D'autres avantages, buts et caractéristiques de la présente invention ressortent de la description détaillée qui suit, faite à titre d'exemple non limitatif, au regard des dessins annexés dans lesquels :
- la figure 1 présente un container comprenant un module informatique pour centre d'hébergement informatique transportable selon un mode de réalisation de l'invention, vu du dessus ;
- les figures 2 et 3 présentent des exemples d'assemblage de modules informatiques, dans un container, pour centre d'hébergement informatique transportable selon des modes de réalisation de l'invention, également vus de dessus ;
- la figure 4 présente une variante du container illustré sur la figure 3, vue en perspective ;
- les figures 5 à 7 présentent des exemples de centres d'hébergement informatique transportables selon des modes de réalisation de l'invention, vus du dessus ;
- la figure 8 présente une variante du centre d'hébergement de la figure 7, vue en perspective ; et,
- la figure 9 présente une variante de centre d'hébergement selon l'invention.

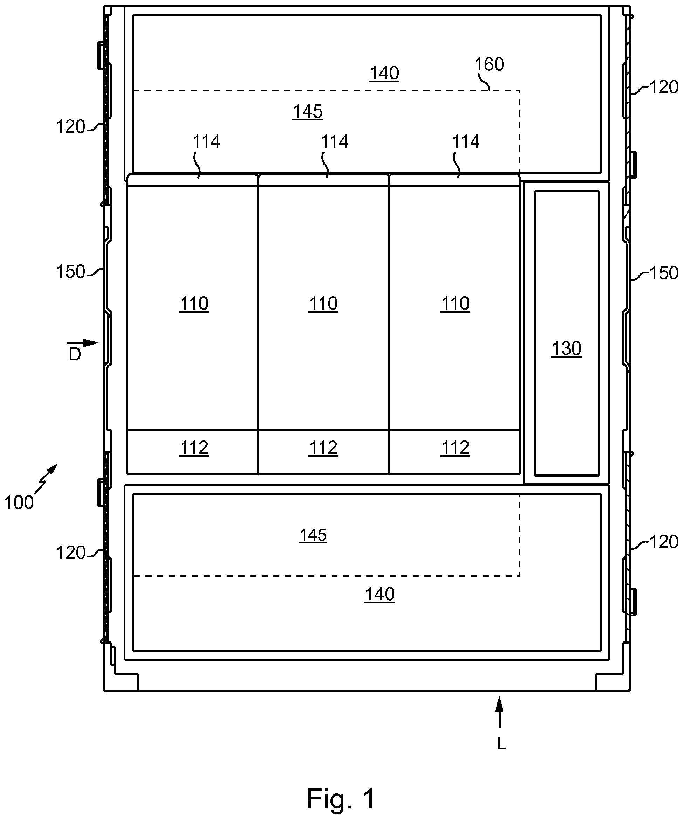

En figure 1, on a représenté un container de transport 100 de 10 pieds de longueur (soit environ 3 m.) suivant la direction principale longitudinale L, vu du dessus et comprenant un module informatique 160. Le container a une forme essentiellement parallélépipédique rectangle avec une hauteur de 2,40 m sur 2,35 m de largeur intérieure.

Le module informatique 160 situé à l'intérieur du container 100 comprend ici une rangée de trois armoires informatiques 110 dressées les unes à côté des autres selon une direction principale de développement D, perpendiculaire à la direction principale longitudinale L. Ces armoires 110 sont chacune de forme parallélépipédique rectangle, leurs grands côtés étant disposés selon la direction L. Chacune d'entre elles présente sur l'une de ses deux façades (petits côtés) un climatiseur 112, ainsi que sur la façade opposée une porte de maintenance principale 114, servant notamment à l'introduction et à l'extraction des équipements informatiques principaux. La façade portant un climatiseur comprend également une porte de maintenance secondaire pouvant servir, en particulier, à effectuer le câblage et à mettre en place des disques durs et des systèmes d'alimentation électrique. Les trois armoires 110 sont disposées de telle sorte que les climatiseurs 112 sont tous les trois sur le même côté de la rangée alors que les portes de maintenance principales 114 sont toutes les trois sur la façade opposée de la rangée.

La rangée d'armoires 110 débute ici au contact (ou dans une variante à proximité) d'une paroi latérale 150 du container. A l'opposé de la paroi 150 avec laquelle elle est en contact, la rangée d'armoires 110 s'achève sur un espace vide pouvant servir d'allée longitudinale 130 pour un opérateur humain.

De part et d'autre de la rangée d'armoires 110, sont présents deux espaces vides pouvant servir d'allées transversales 140. Chacune des allées transversales 140 débouche sur une porte latérale 120 installée dans la paroi latérale du container, à chacune de ses extrémités. Le container 100 comporte ainsi quatre portes latérales 120. Un opérateur humain entrant dans le container 100 par l'une quelconque des portes 120 peut se déplacer par les allées transversales et l'allée longitudinale pour rejoindre une autre quelconque des portes 120.

Le module informatique 160 comprend, outre les armoires informatiques 110, la moitié d'allée 145 de chacune des allées 140 courant le long des armoires 110, depuis la paroi 150 contre laquelle débute la rangée d'armoires, jusqu'à l'extrémité de la rangée d'armoires où débute l'allée longitudinale 130. Cela est représenté par des pointillés en figure 1.

Un tel motif est destiné à être répliqué dans des containers de différentes longueurs. Dans le container de 10 pieds qui fait l'objet de la figure 1, le module ainsi défini est complété par l'allée 130, deux demi-allées latérales formant avec les moitiés d'allée 145 les allées 140 aux deux extrémités du container, ainsi que deux espaces dans le prolongement commun des allées latérales 140 et de l'allée longitudinale 130.

Les containers utilisés peuvent notamment avoir différentes longueurs, répondant ou non aux standards de transport.

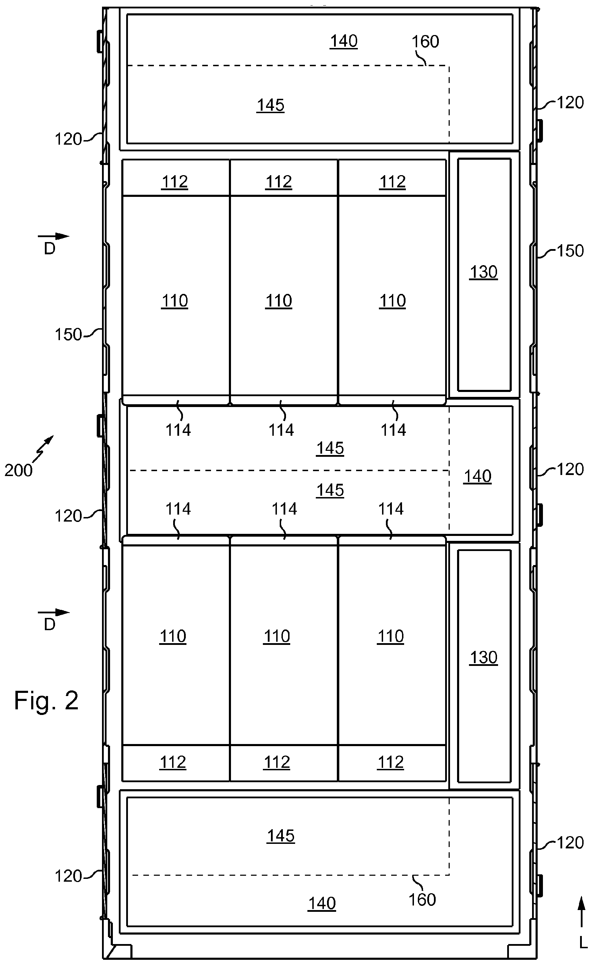

En figure 2, on a représenté un container 200 de 20 pieds de long. Un tel container reprend des éléments décrits en figure 1 en relation avec le container 100 de 10 pieds de long. Le container 200 comprend deux rangées d'armoires 110 disposées parallèlement l'une à l'autre suivant une direction principale de développement D perpendiculaire à la direction principale longitudinale L du container, ainsi que trois allées transversales 140 dont l'une sépare les deux rangées d'armoires 110. Le container 200 comprend également deux allées longitudinales 130 raccordant les allées transversales 140, ainsi que six portes latérales 120 dans les parois latérales 150. Les deux allées longitudinales 130 sont dans le prolongement l'une de l'autre, mais dans une variante, elles longent l'une une des parois latérales 150 du container, et l'autre la paroi latérale 150 opposée.

Ainsi, un opérateur humain entrant dans le container 200 par l'une quelconque des portes 120 peut se déplacer dans le container 200, accéder à l'avant ou à l'arrière de l'une quelconque des armoires 110 et ressortir du container 200 par l'une quelconque des portes 120. L'allée 140 séparant les deux rangées d'armoires 110 donne accès aux portes de maintenance principales 114 des six armoires.

A l'inverse, les deux allées transversales 140 aux deux extrémités du container 200 donnent accès, chacune, aux climatiseurs 112 de trois armoires 110, ainsi qu'à une porte de maintenance secondaire pour effectuer le câblage ou introduire des disques durs. Pour cela, les armoires 110 de la première rangée d'armoires sont disposées dans une configuration inversée ou « tête-bêche » par rapport aux armoires 110 de la deuxième rangée. Ainsi, l'allée transversale centrale donnant accès aux portes de maintenance principales 114 est une allée dite « froide », à partir de laquelle les armoires admettent de l'air froid pour leur refroidissement, et les allées transversales 140 donnant accès aux climatiseurs sont des allées « chaudes » dans lesquelles est rejeté l'air chaud issu des climatiseurs 112. La circulation d'air se fait par ailleurs par le bas et le haut de l'unité (non représenté).

On reconnaît dans cet assemblage deux modules informatiques 160 tels que définis précédemment, disposés « tête-bêche » l'un par rapport à l'autre. Ils sont représentés par des pointillés sur la figure 2. Ils sont complétés par deux demi-allées latérales formant avec les demi-allées 145 aux extrémités de l'assemblage de modules les allées 140 aux deux extrémités du container, ainsi que deux allées longitudinales 130 et trois espaces dans le prolongement des allées latérales 140 et des allées longitudinales 130.

On précise que le container 200 pourrait ne contenir qu'un seul module informatique 160, l'espace ainsi libéré étant utilisé d'une autre manière, ou étant laissé vide, momentanément ou non.

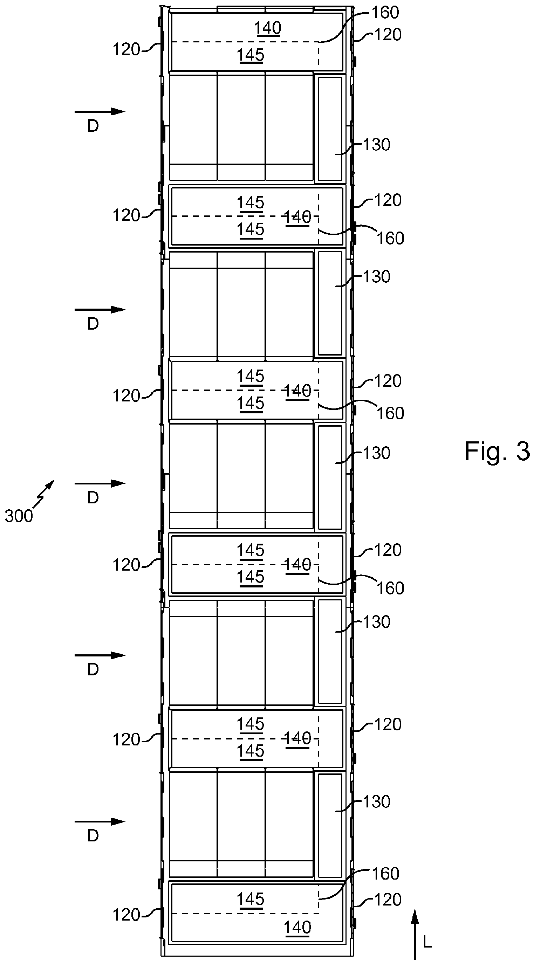

En figure 3, on a représenté un container 300 de 40 pieds. Un tel container comprend six allées transversales 140 et cinq rangées d'armoires 110 disposées parallèlement les unes aux autres suivant une direction principale de développement D perpendiculaire à la direction principale longitudinale L du container. Il y a également cinq allées longitudinales 130, et douze portes latérales 120. Les allées longitudinales sont ici dans le prolongement les unes des autres, mais elles pourraient être disposées indépendamment les unes des autres longeant l'une ou l'autre des deux parois latérales du container. Le nombre d'armoires 110 est porté à 15. Les armoires sont, comme en figure 2, disposées en configuration «tête-bêche», et trois des allées 140 sont des allées «chaudes», alors que trois autres des allées 140 sont des allées « froides ».

On reconnaît dans cet assemblage cinq modules informatiques 160 (figurés par des pointillés) tels que définis précédemment, disposés «tête-bêche ». Ils sont là aussi complétés par deux demi-allées latérales formant avec les demi-allées 145 aux extrémités de l'assemblage de modules les allées 140 aux deux extrémités du container, ainsi que par les cinq allées longitudinales 130 et six espaces dans le prolongement des allées latérales 140 et des allées longitudinales 130.

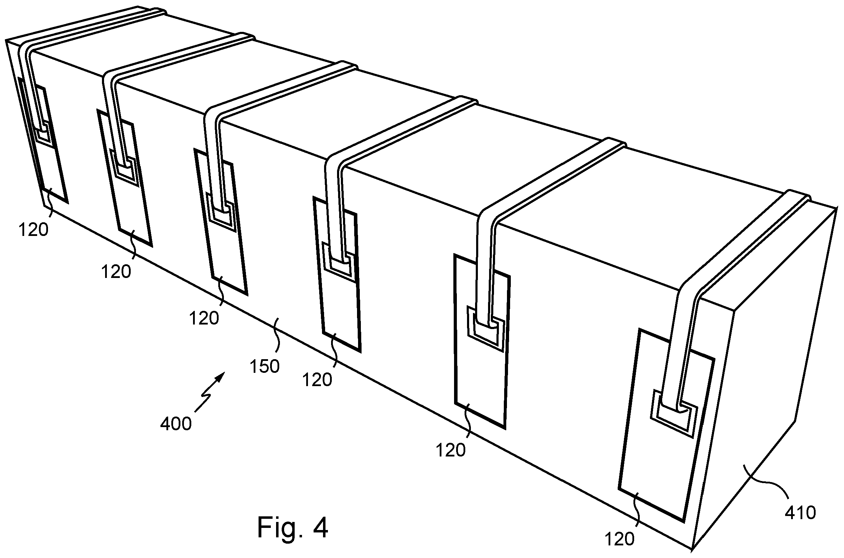

En figure 4, on a représenté une vue extérieure d'un tel container de 40 pieds de long. Le container 400 est présenté en vue de trois quarts. On aperçoit sur la paroi latérale 150 six portes latérales 120, et également, à droite de l'image, une porte frontale 410 pouvant s'ouvrir sur un côté, sur le bas ou le haut ou en son milieu, le container 400 comportant de plus une deuxième porte frontale 410 à son autre extrémité (cachée sur la figure 4). De telles portes frontales peuvent notamment être utilisées pour introduire des armoires 110 dans le container.

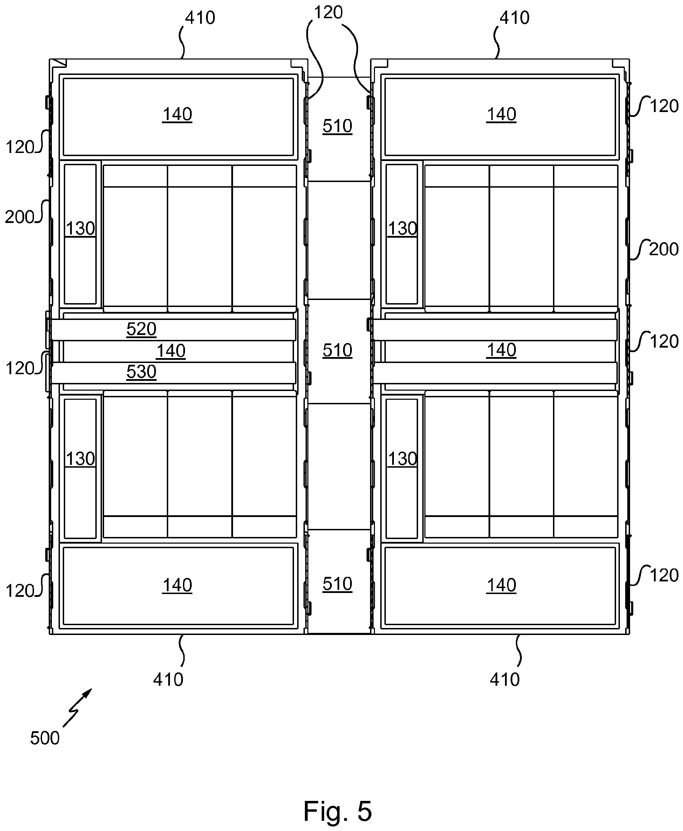

En figure 5, on a représenté un centre 500 d'hébergement informatique basé sur la mise en oeuvre de plusieurs containers tels que ceux illustrés sur la figure 2. Il comprend ici deux fois six armoires. Ce centre 500 comporte deux containers 200 de vingt pieds, disposées parallèlement l'un à l'autre, côte à côte. Les portes frontales 410 des deux containers sont alignées deux à deux dans deux plans frontaux et les allées longitudinales 130 sont toutes du même côté des containers, ce qui a pour conséquence qu'un des containers se déduit de l'autre par une translation horizontale parallèlement aux plans frontaux. A titre de variante, on aurait pu présenter deux containers 200 disposés « tête bêche » l'un par rapport à l'autre.

Trois couloirs de communication 510 sont disposés entre les containers 200. Chacun de ces couloirs de communication 510 relie deux portes latérales 120 se faisant face.

Ainsi, un opérateur humain entrant par l'une quelconque des six portes 120 libres se situant sur les parois latérales les plus à gauche et à droite du centre 500 sur la figure 5 peut se déplacer dans le centre 500 en suivant les allées longitudinales 130 et les allées transversales 140, accéder aux deux façades de l'une quelconque des armoires 110 et ressortir du centre 500 par l'une quelconque des portes 120 donnant sur l'extérieur du centre.

On a également représenté l'arrivée d'eau froide 520 et la sortie d'eau chaude 530 relatives aux containers 200.

La figure 5 est, s'agissant des allées transversales 140 du milieu des containers 200, une vue en écorché puisque les canalisations 520 et 530 sont installées sous le plancher de ces allées transversales 140.

Dans un mode de réalisation, une canalisation (non représentée) flexible ou rigide est placée dans le prolongement de la canalisation 520 pour relier celle-ci à la canalisation 520 du deuxième container 200. De manière similaire, la canalisation 530 est raccordée à la canalisation correspondante du deuxième container 200.

Dans le centre 500, on a installé les armoires 110 de telle sorte que l'allée 140 froide du premier container 200 est dans le prolongement de l'allée 140 froide du deuxième container 200 alors que chacune des allées 140 chaudes du premier container 200 est dans le prolongement d'une allée 140 chaude du deuxième container 200. On note que les canalisations 520 et 530 sont placées sous le plancher des allées 140 froides, ce qui permet une entrée et une sortie d'eau dans les armoires par la façade portant les portes de maintenance principales 114.

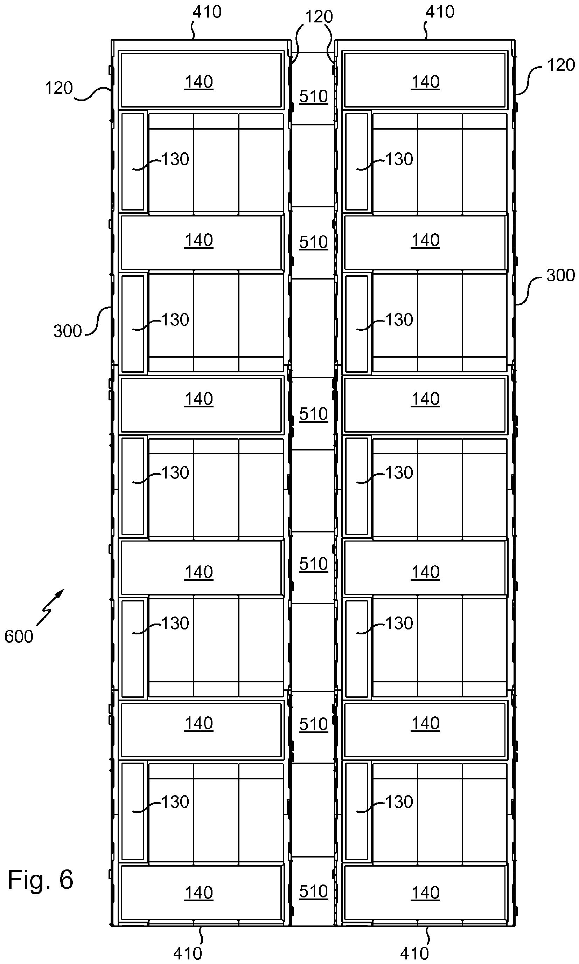

En référence à la figure 6, on a représenté un centre 600 d'hébergement de deux fois quinze armoires. Celui-ci comprend deux containers 300 de 40 pieds disposés l'une à côté de l'autre parallèlement l'un à l'autre, les portes frontales 410 étant alignées deux à deux. Six couloirs de communication 510 sont disposés entre les deux containers 300. Un opérateur humain entrant par l'une quelconque des portes latérales 120 s'ouvrant sur l'extérieur peut se déplacer dans le centre 600, accéder à l'avant et à l'arrière de chacune des deux armoires 110 et ressortir du centre 600 par l'une quelconque des portes latérales 120 donnant sur l'extérieur.

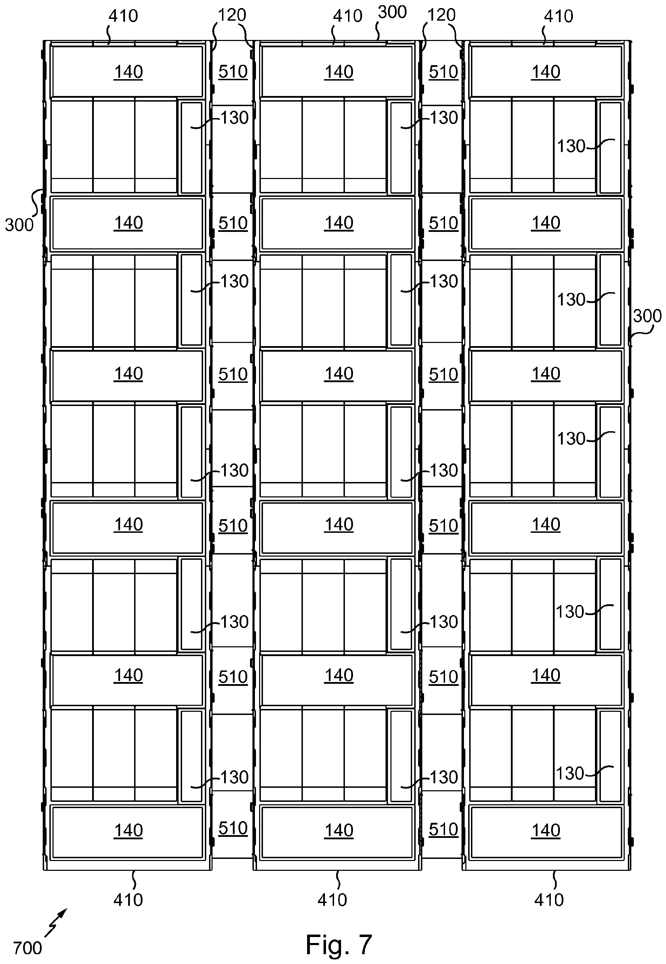

En figure 7, on a représenté un centre 700 d'hébergement de trois fois quinze armoires. Celui-ci est constitué de trois containers 300 de 40 pieds. Ceux-ci sont disposées parallèlement l'un à l'autre côte à côte, les portes latérales 120 étant alignées. Six couloirs de communication 510 relient le premier container 300 au deuxième container 300 sur l'une de ses faces latérales. Six autres couloirs de communication 510 relient le deuxième container 300 au troisième container 300 sur sa deuxième face latérale. Ainsi, le deuxième container 300 ne dispose pas de porte latérale 120 donnant sur l'extérieur puisque toutes les portes latérales 120 de ce container donnent sur des couloirs de communication 510.

On précise que les trois containers 300 sont orientés de la même manière, ce qui se traduit sur la figure 7 par le fait que les allées longitudinales 130 sont toutes les quinze du côté droit du container 300 correspondant.

Aux figures 5 à 7, on appréciera qu'une variante est obtenue en ne mettant en place des allées longitudinales 130 que dans un des containers, et que la circulation entre deux allées transversales 140 dans un même container peut nécessiter alors de franchir un couloir de communication 510, de contourner des armoires dans le container voisin, puis de franchir un deuxième couloir de communication 510. L'espace ainsi dégagé peut être utilisé pour du matériel informatique de différentes dimensions.

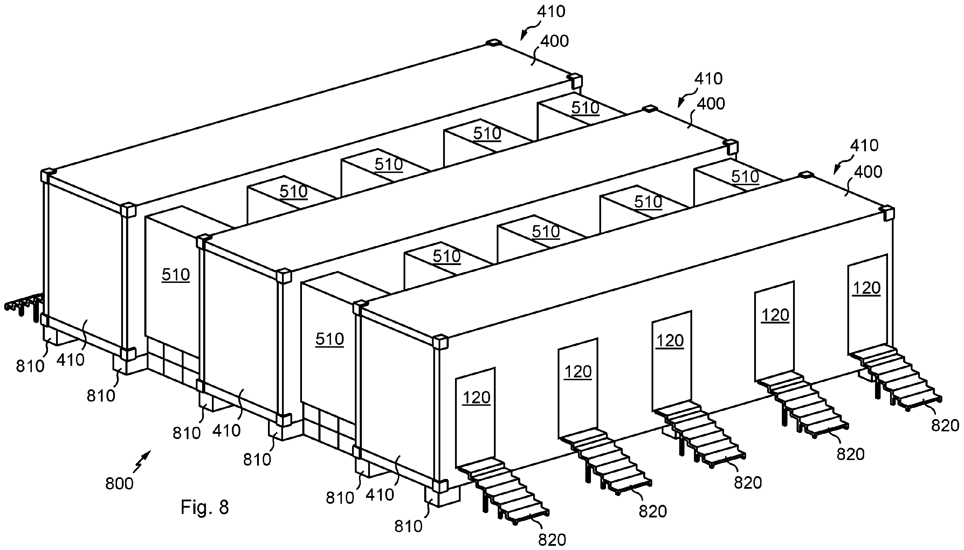

En référence à la figure 8, on a représenté une vue de trois quarts du centre d'hébergement 800. On reconnaît trois containers 400 de 40 pieds ainsi que leurs portes frontales 410 et les couloirs de communication 510 les reliant les uns aux autres et qui sont ici au nombre de 10, soit cinq couloirs de communication entre chaque paire de containers 400 adjacents. Chacun des containers est posé sur des plots 810, par exemple en béton. Des escaliers 820 permettent ici d'accéder aux portes latérales 120 débouchant sur l'extérieur du centre d'hébergement 800.

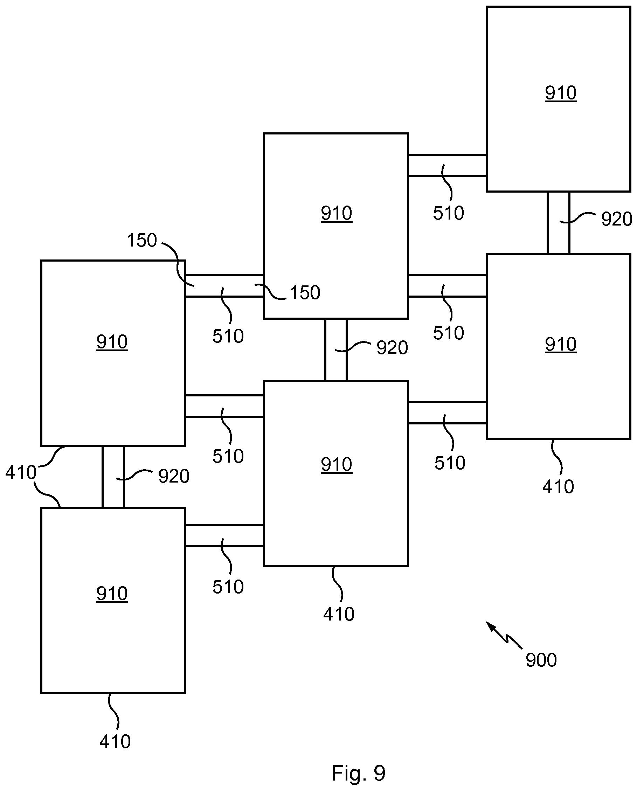

Enfin, en figure 9, on a représenté schématiquement un centre d'hébergement 900 comprenant six containers 910. Les containers 910 sont alignés dans la direction principale longitudinale deux par deux, et leurs portes frontales 410 sont décalées les unes par rapport aux autres. Ainsi, des containers 910 sont alignés suivant une direction transversale à la direction principale longitudinale. Bien que cette direction transversale soit ici perpendiculaire à la direction longitudinale, elle peut être différente, par exemple inclinée de 60°.

Des couloirs de communication 510 relient respectivement une porte latérale 150 d'un container 910 à une porte latérale 150 d'un container 910 voisin. Dans un mode préféré, deux containers 910 alignés dans la direction longitudinale communiquent par le simple raccordement de parois, mais dans une variante, un couloir de communication longitudinale 920 est installé entre les deux portes frontales 410 se faisant face.

On appréciera ainsi, au regard des exemples présentés notamment aux figures 5 à 9, qu'un centre d'hébergement informatique selon l'invention peut être mis en place sur de nombreux types de terrains en fonction de l'espace disponible et de la puissance informatique souhaitée avec une flexibilité bien améliorée par rapport aux systèmes précédemment décrits. Un tel centre présente l'avantage qu'un opérateur humain peut circuler dans l'ensemble de l'espace utilisé et accéder à l'avant et à l'arrière de toutes les armoires présentes dans le centre, sans ressortir de celui-ci.

L'invention ne se limite pas aux modes de réalisation décrits, mais s'étend à toutes les variantes à la portée de l'homme du métier.

## Revendications

1. Centre d'hébergement informatique transportable comprenant :
au moins un container de transport (100), ledit au moins un container s'étendant horizontalement suivant une direction principale longitudinale (L) ;
au moins un module informatique (160), ledit module informatique étant disposé à l'intérieur dudit au moins un container de transport et comprenant une rangée d'au moins deux armoires informatiques (110) disposées côte à côte et s'étendant horizontalement suivant une direction principale de développement (D) orthogonale à ladite direction principale longitudinale (L), les deux dites armoires informatiques formant un ensemble d'équipements informatiques et présentant chacune deux faces latérales opposées devant lesquelles sont formés des espaces d'accès (145) ; et
des allées de circulation transversales (140) de part et d'autre de la rangée d'armoires informatiques (110) ainsi qu'une allée de circulation longitudinale (130) reliant les allées de circulation transversales, lesdites allées de circulation transversales et longitudinale permettant à un opérateur humain de se déplacer dans le container et d'accéder aux deux faces latérales opposées de l'une quelconque des armoires informatiques, au niveau desdits espaces d'accès.

2. Centre d'hébergement informatique selon la revendication 1, selon lequel ledit au moins un container comporte au moins une porte (120) sur une paroi latérale (150) débouchant sur une desdites allées de circulation transversale (140), ladite allée de circulation transversale comprenant l'un desdits espaces d'accès (145), la porte et l'allée pouvant être empruntées par un opérateur humain.

3. Centre d'hébergement informatique selon l'une des revendications 1 et 2, selon lequel ladite allée de circulation longitudinale (130) longe une paroi (150) dudit au moins un container.

4. Centre d'hébergement informatique selon l'une quelconque des revendications précédentes, selon lequel les deux dites armoires informatiques (110) sont de forme parallélépipédique rectangle.

5. Centre d'hébergement selon l'une quelconque des revendications 1 à 4, comprenant au moins deux modules informatiques dont les directions principales de développement (D) sont parallèles entre elles.

6. Centre d'hébergement selon la revendication précédente selon lequel lesdits ensembles d'équipements informatiques (110) respectifs desdits au moins deux modules informatiques présentent chacun une façade latérale portant une sortie d'air chaud d'un système de réfrigération (112), lesdites façades latérales desdits ensembles d'équipements informatiques (110) respectifs desdits au moins deux modules informatiques se faisant face.

7. Centre d'hébergement selon la revendication 5 ou selon la revendication 6, selon lequel chacun desdits ensembles d'équipements informatiques (110) desdits au moins deux modules informatiques comprend au moins un système de réfrigération (112), ledit au moins un système de réfrigération comprenant une alimentation hydraulique, ladite alimentation hydraulique étant issue d'une canalisation commune (520) disposée sous un plancher entre lesdits ensembles d'équipements informatiques desdits au moins deux modules informatiques.

8. Centre d'hébergement informatique selon l'une quelconque des revendications 1 à 7, comprenant au moins deux containers disposés parallèlement les uns aux autres et alignés dans une direction transversale à ladite direction principale longitudinale desdits au moins deux containers.

9. Centre d'hébergement informatique selon la revendication 8, selon lequel au moins deux containers alignés dans une direction transversale auxdites directions principales longitudinales sont reliés par un couloir (510).

## Patentansprüche

1. Transportables Informatik-Hostcenter, umfassend:
wenigstens einen Transportcontainer (100), wobei sich der wenigstens ein Container horizontal entlang einer Hauptlängsrichtung (L) erstreckt;
wenigstens ein Informatikmodul (160), wobei das Informatikmodul im Inneren des wenigstens einen Transportcontainers angeordnet ist und eine Reihe von wenigstens zwei Informatikschränken (110) umfasst, die nebeneinander angeordnet sind und sich horizontal entlang einer Hauptverlaufsrichtung (D) erstrecken, die rechtwinklig zu der Hauptlängsrichtung (L) ist, wobei die zwei Informatikschränke eine Informatikanlageneinheit bilden und jeweils zwei gegenüberliegende Seitenflächen aufweisen, vor denen Zugangsräume (145) gebildet sind; und
Quergänge (140) zu beiden Seiten der Reihe von Informatikschränken (110) sowie einen Längsgang (130), der die Quergänge miteinander verbindet, wobei die Quer- und Längsgänge es einer menschlichen Bedienungsperson erlauben, sich in dem Container zu bewegen und im Bereich der Zugangsräume Zugang zu den zwei gegenüberliegenden Seitenflächen von einem der Informatikschränke zu erhalten.

2. Informatik-Hostcenter nach Anspruch 1, wobei der wenigstens ein Container wenigstens eine Tür (120) in einer Seitenwand (150) aufweist, die in einen der Quergänge (140) mündet, wobei der die Quergänge einen der Zugangsräume (145) umfasst, wobei die Tür und der Gang von einer menschlichen Bedienungsperson genutzt werden können.

3. Informatik-Hostcenter nach einem der Ansprüche 1 und 2, wobei der Längsgang (130) eine Wand (150) des wenigstens eines Containers entlangläuft.

4. Informatik-Hostcenter nach einem der vorhergehenden Ansprüche, wobei die zwei Informatikschränke (110) eine rechteckige parallelepipedische Form aufweisen.

5. Hostcenter nach einem der Ansprüche 1 bis 4, umfassend wenigstens zwei Informatikmodule, deren Hauptverlaufsrichtungen (D) zueinander parallel sind.

6. Hostcenter nach dem vorhergehenden Anspruch, wobei die jeweiligen Informatikanlageneinheiten (110) der wenigstens zwei Informatikmodule jeweils eine Seitenfassade aufweisen, die einen Heißluftaustritt eines Kühlsystems (112) trägt, wobei die Seitenfassaden der jeweiligen Informatikanlageneinheiten (110) der wenigstens zwei Informatikmodule einander zugewandt sind.

7. Hostcenter nach Anspruch 5 oder nach Anspruch 6, wobei jede der Informatikanlageneinheiten (110) der wenigstens zwei Informatikmodule wenigstens ein Kühlsystem (112) umfasst, wobei das wenigstens ein Kühlsystem eine Hydraulikversorgung umfasst, wobei die Hydraulikversorgung aus einer gemeinsamen Leitung (520) stammt, die unter einem Fußboden zwischen den Informatikanlageneinheiten der wenigstens zwei Informatikmodule angeordnet ist.

8. Informatik-Hostcenter nach einem der Ansprüche 1 bis 7, umfassend wenigstens zwei Container, die parallel zueinander angeordnet sind und in einer Richtung quer zur Hauptlängsrichtung der wenigstens zwei Container ausgerichtet sind.

9. Informatik-Hostcenter nach Anspruch 8, wobei wenigstens zwei Container, die in einer Richtung quer zu den Hauptlängsrichtungen ausgerichtet sind, durch einen Korridor (510) miteinander verbunden sind.

## Claims

1. A transportable information technology hosting center comprising:
at least one transport container (100), said at least one container extending horizontally in a main longitudinal direction (L);
at least one information technology module (160), said information technology module being disposed inside said at least one transport container and comprising a row of at least two racks (110) disposed side by side and extending horizontally in a main direction of extension (D) orthogonal to said main longitudinal direction (L), the two said racks forming a set of information technology equipment and each having two opposite lateral faces in front of which are formed access spaces (145); and
transverse passage (140) on both sides of the row of racks (110) as well as a longitudinal passage (130) linking the transverse aisles passage, said transverse and longitudinal passage enabling a human operator to move inside the container and to access both of the opposite lateral faces of any one of the racks, at the location of said access spaces.

2. An information technology hosting center according to claim 1, in which said at least one container comprises at least one door (120) on a lateral wall (150) enabling into to one of said transverse passage (140), said transverse passage comprising one of said access spaces (145), it being possible for a human operator to pass through the door and go along the aisle.

3. An information technology hosting center according to one of claims 1 and 2, in which said longitudinal passage (130) passes alongside a wall (150) of said at least one container.

4. An information technology hosting center according to any one of the preceding claims, in which the two said racks (110) have a rectangular parallelepipedic shape.

5. A hosting center according to any one of claims 1 to 4, comprising at least two information technology modules of which the main directions of extension (D) are parallel to each other.

6. A hosting center according to the preceding claim in which said respective sets of information technology equipment (110) of said at least two information technology modules each have a lateral facade bearing a hot air outlet for a refrigeration system (112), said lateral facades of said respective sets of information technology equipment (110) of said at least two information technology modules facing each other.

7. A hosting center according to claim 5 or claim 6, in which each of said sets of information technology equipment (110) of said at least two information technology modules comprises at least one refrigeration system (112), said at least one refrigeration system comprising a hydraulic supply, said hydraulic supply coming from common piping (520) disposed under a floor between said sets of information technology equipment of said at least two information technology modules.

8. An information technology hosting center according to any one of claims 1 to 7, comprising at least two containers disposed parallel to each other and aligned in a direction transverse to said main longitudinal direction of said at least two containers.

9. An information technology hosting center according to claim 8, in which at least two containers aligned in a direction transverse to said longitudinal main directions are linked by a corridor (510).
